(19)

Europäisches
Patentamt
European
Patent Office
Office européen
des brevets

(11)     **EP 1 517 959 B1**

(12)                     **EUROPEAN PATENT SPECIFICATION**

(45) Date of publication and mention
of the grant of the patent:
**11.03.2009 Bulletin 2009/11**

(21) Application number: **03736789.3**

(22) Date of filing: **04.06.2003**

(51) Int Cl.:
*C08L 67/06* (2006.01)     *C08F 8/14* (2006.01)
*B05D 3/02* (2006.01)      *C08J 5/08* (2006.01)
*C08J 5/04* (2006.01)      *C08L 67/00* (2006.01)
*D04H 1/64* (2006.01)

(86) International application number:
**PCT/US2003/017279**

(87) International publication number:
**WO 2003/106561 (24.12.2003 Gazette 2003/52)**

(54) **POLYESTER-TYPE FORMALDEHYDE FREE INSULATION BINDER**

FORMALDEHYDFREIES ISOLIERUNGSBINDEMITTEL VOM POLYESTERTYP

LIANT POUR ISOLANT AU POLYESTER EXEMPT DE FORMALDEHYDE

(84) Designated Contracting States:
**AT BE BG CH CY CZ DE DK EE ES FI FR GB GR
HU IE IT LI LU MC NL PT RO SE SI SK TR**

(30) Priority: **18.06.2002 US 389295 P**

(43) Date of publication of application:
**30.03.2005 Bulletin 2005/13**

(73) Proprietor: **Georgia-Pacific Chemicals LLC
Atlanta GA 30303 (US)**

(72) Inventors:
• **TUTIN, Kim
Stone Mountain, GA 30087 (US)**
• **RODRIGUEZ, Augie
Georgia 30017 (US)**
• **HINES, John
Atlanta, GA 30307 (US)**
• **GABRIELSON, Kurt
Lilburn, GA 30047 (US)**
• **HAGIOPOL, Cornel
Lilburn, GA 30047 (US)**

• **SRNINIVASAN, Ramji
Duluth, GA 30090 (US)**
• **WHITE, Randy
Conyers, GA 30013 (US)**

(74) Representative: **Tombling, Adrian George et al
Withers & Rogers LLP
Goldings House
2 Hays Lane
London
SE1 2HW (GB)**

(56) References cited:
EP-A- 0 004 053     EP-A- 0 353 493
EP-A- 0 583 086     WO-A-95/30061
US-A- 4 029 623     US-A- 4 054 713
US-A- 4 220 752     US-A- 4 477 496
US-A- 5 091 465     US-A- 5 340 868
US-A- 5 393 849     US-A- 5 932 665
US-A- 5 977 232     US-A- 6 114 464
US-A1- 2001 029 280     US-B1- 6 171 654

**Description**

FIELD OF THE INVENTION

The present invention relates to a new formaldehyde-free binder composition, to the related method of its use for making fiberglass insulation and related fiberglass products (glass fiber products) and to the glass fiber products themselves. The present invention particularly relates to an aqueous binder composition containing a substantially infinitely water-dilutable or water-dispersible adduct of a monomeric polycarboxylic acid component (polybasic acid) and a monomeric polyol component, i.e., a polyester.

BACKGROUND OF THE INVENTION

Phenol-formaldehyde (PF) resins, as well as PF resins extended with urea (PFU resins), have been the mainstays of fiberglass insulation binder technology over the past several years. Such resins are inexpensive and provide the cured fiberglass insulation product with excellent physical properties.

One of the drawbacks of this technology, however, is the potential for formaldehyde emissions during the manufacturing of the fiberglass insulation. Fiberglass insulation is typically made by spaying a dilute aqueous solution of the PF or PFU resin binder onto a moving mat or blanket of non-woven glass fibers, often hot from being recently formed, and then heating the mat or blanket to an elevated temperature in an oven to cure the resin. Manufacturing facilities using PF and PFU resins as the main binder component for insulation products recently have had to invest in pollution abatement equipment to minimize the possible exposure of workers to formaldehyde emissions and to meet Maximum Achieveable Control Technology (MACT) requirement Standards.

As an alternative to PF and PFU resins, certain formaldehyde free formulations have been developed for use as a binder for making fiberglass insulation products. One of the challenges to developing suitable alternatives, however, is to identify formulations that have physical properties (viscosity, dilutability, etc.) and other characteristics similar to the standard PF and PFU resins, i.e., formulations which also have a similar cure time/cure temperature profile, while yielding a cured fiberglass insulation product with equivalent physical properties.

U.S. 5,318,990 describes a formaldehyde free formulation for fiberglass insulation based on an aqueous solution of a polymeric carboxylic acid, such as a polyacrylic acid, and a triol, such as glycerol, trimethylolpropane and the like. Other polyols may optionally be present. The formulation relies on the presence of a phosphorus accelerator (catalyst) in the aqueous solution to obtain an effective cure at suitable temperatures.

U.S. 5,340,868 describes a binder for making a fiberglass mat comprising an aqueous solution of a polymeric carboxylic acid, such as polyacrylic acid, a β-hydroxyalkylamide and an at least tri-functional monomeric carboxylic acid, such as citric acid, trimetallitic acid, hemimellitic acid, trimesic acid, tricarballylic acid, 1,2,3,4-butanetetracarboxylic acid (BTCA) and pyromellitic acid.

U.S. 5,393,849 describes a curable composition useful in making binder formulations made by combining an unsaturated polyester resin and a polyamino compound.

U.S. 5,661,213 describes a formaldehyde free formulation for fiberglass insulation based on an aqueous solution of a polyacid, such as a polyacrylic acid, and a polyol (at least a diol), with a molecular weight less than about 1000 such as, for example, ethylene glycol, glycerol, pentaerythritol, trimethylol propane, sorbitol, sucrose, glucose, resorcinol, catechol, pyrogallol, glycollated ureas, 1,4-cyclohexane diol, diethanolamine, triethanolamine, and certain reactive polyols such as, for example, β-hydroxyalkylamides. The formulation relies on the presence of a phosphorus accelerator (catalyst) in the aqueous solution to obtain an effective cure at suitable temperatures.

U.S. 5,932,689 describes a formaldehyde free formulation for fiberglass insulation based on a combination of three components (1) a polyacid, such as polyacrylic acid, (2) an active hydrogen-containing compound, such as a polyol, or a polyamine, and (3) a cyanamide, a dicyanamide or a cyanoguanidine. In this formulation, an accelerator (catalyst) is said to be optional. Suitable accelerators include a phosphorus or fluoroborate compound.

U.S. 5,977,232 describes a formaldehyde free formulation for fiberglass insulation based on a combination of three components (1) a polyacid, such as polyacrylic acid, (2) an active hydrogen-containing compound, such as a polyol, or a polyamine, and (3) a fluoroborate accelerator.

U.S. 6,114,464 describes a binder for producing shaped articles, such as chipboard, comprising a curable composition of an addition polymer of an unsaturated mono- or dicarboxylic acid and a multi-hydroxyalkylated polyamine.

U.S. 6,171,654 describes preparing fiberglass insulation using a water soluble or water-dispersible curable polyester resin binder formed by reacting a polyol, such as pentaerythritol, a terephthalate polymer, such as recycled polyethylene terephthalate (PET), a polyacid, such as isophthalic and terephthalic acid, an end (mono-functional) acid, a reactive diluent (crosslinker) such as a melamine resin, and an acid catalyst.

U.S. 6,331,350 describes a binder formulation for fiberglass very similar to U.S. 5,661,213 except that the pH of the aqueous solution is adjusted to less than 3.5.

Despite these disclosures, there is a continuing need for identifying new formaldehyde-free, curable aqueous compositions suitable for use as a binder for fiberglass, especially for making glass fiber products such as fiberglass insulation.

## DETAILED DESCRIPTION OF THE INVENTION

The present invention is directed to a polyester binder composition and the related method of its use for making glass fiber insulation products and related products, such as thin fiberglass mats (all hereinafter referred to generically as glass fiber products) and the glass fiber products, especially fiberglass insulation products, made with the cured (crosslinked) polyester binder. The present invention particularly relates to an aqueous polyester binder composition containing a substantially infinitely water-dilutable or water-dispersible thermosetting adduct of a monomeric polycarboxylic acid component (polybasic acid) and a monomeric polyol component.

The binder is applied as a dilute aqueous solution to a mat of glass fibers and cured by heat.

As used herein, "curing," "cured" and similar terms are intended to embrace the structural and/or morphological change which occurs in the aqueous polyester binder of the present invention as it is dried and then heated to cause the properties of a flexible, porous substrate, such as a mat or blanket of glass fibers to which an effective amount of the binder has been applied, to be altered such as, for example, by covalent chemical reaction, ionic interaction or clustering, improved adhesion to the substrate, phase transformation or inversion, and hydrogen bonding.

By "formaldehyde-free" is meant that the composition is substantially free from formaldehyde, and does not liberate substantial formaldehyde as a result of drying and/or curing; typically, less than 1 ppm formaldehyde, based on the weight of the composition, is present in a formaldehyde-free composition. In order to minimize the formaldehyde content of the composition it is preferred to use additives that are themselves free from formaldehyde and do not generate formaldehyde during drying and/or curing.

As used herein, "aqueous" includes water and mixtures composed substantially of water and water-miscible solvents.

As used herein the phrases "glass fiber," fiberglass" and the like are intended to embrace heat-resistant fibers suitable for withstanding elevated temperatures such as mineral fibers, aramid fibers, ceramic fibers, metal fibers, carbon fibers, polyimide fibers, certain polyester fibers, rayon fibers, and especially glass fibers. Such fibers are substantially unaffected by exposure to temperatures above about 120° C. If intended to embrace predominately and/or only fibers made from glass, i.e., a material made predominately from silica, then a phrase such as "principally glass fiber" or "only glass fiber," respectively will be used.

As used throughout the specification and claims, the terms mat and blanket are used somewhat interchangeably to embrace a variety of glass fiber substrates of a range of thickness and density, made by entangling short staple fibers, long continuous fibers and mixtures thereof.

As used herein, the term "acid number" is a measure of the free carboxylic acid content of a polyester resin binder and refers to number of milligrams (mg) of potassium hydroxide (KOH) needed to neutralize the free carboxylic acid in one gram of polyester resin binder solids.

In a first aspect, the present invention is directed to an aqueous binder composition containing a substantially infinitely water-dilutable adduct or alternatively a substantially infinitely water dispersible adduct of a monomeric polycarboxylic acid component and a monomeric polyol component.

In another aspect, the present invention provides a method for binding together a loosely associated mat or blanket of glass fibers comprising (1) contacting said glass fibers with a curable polyester composition as defined above, and (2) heating said curable polyester composition at an elevated temperature, which temperature is sufficient to effect cure. Preferably, curing is effected at a temperature from 75° C. to 300° C. usually at a temperature less than 250° C.

In yet another aspect, the present invention provides a glass fiber product, especially a glass fiber insulation product, comprising a crosslinked (cured) composition obtained by curing a polyester binder composition as defined above applied to a mat or blanket of nonwoven glass fibers, preferably a mat or blanket of principally glass fibers and especially a mat or blanket of only glass fibers.

The substantially infinitely water-dilutable or infinitely water-dispersible polyester binder resin of the present invention is prepared by reacting a monomeric polycarboxylic acid component with a monomeric polyol component.

As used herein, a "monomeric polycarboxylic acid component" includes polycarboxylic acid compounds with a molecular weight of less than 750, preferably less than 500 and having a plurality of (2 or more) carboxylic acid (-COOH) moieties. If the monomeric polycarboxylic acid component has a distribution of molecular weights then for purpose of this definition the molecular weight is the number average molecular weight of the distribution. By definition, the polymeric acids used in the prior art, such as described in U.S. 5,318,990 and elsewhere, are not to be used in making the polyester binder of the present invention and thus are not embraced by the term monomeric polycarboxylic acid component and the like.

The monomeric polycarboxylic acid component is at least difunctional and is preferably trifunctional or higher. The monomeric polycarboxylic acid component may also have other chemical functional groups (such as hydroxyl groups), so long as such groups do not interfere with the preparation of the polyester binder. Suitable monomeric polycarboxylic acid components are aconitic acid, adipic acid, azelaic acid, butane tetra carboxylic acid dihydride, butane tricarboxylic acid, chlorendic anhydride, citraconic acid, citric acid, dicyclopentadiene-maleic acid adducts, diethylenetriamine pentacetic acid pentasodium salt, adducts of dipentene and maleic anhydride, endomethylenehexachlorophthalic anhydride, ethylenediamine tetraacetic acid (EDTA), fully maleated rosin, maleated tall oil fatty acids, fumaric acid, glutaric acid, isophthalic acid, itaconic acid, maleated rosin-oxidize unsaturation with potassium peroxide to alcohol then carboxylic acid, malic acid, maleic anhydride, mesaconic acid, biphenol A or bisphenol F reacted via the KOLBE-Schmidt reaction with carbon dioxide to introduce 3-4 carboxyl groups, oxalic acid, phthalic anhydride, polylactic acid, sebacic acid, succinic acid, tartaric acid, terephthalic acid, tetrabromophthalic anhydride, tetrachlorophthalic anhydride, tetrahydrophthalic anhydride, trimellitic anhydride and trimesic acid.

A "monomeric polyol component" according to the present invention is a water soluble (substantially infinitely water dilutable) compound having a molecular weight of less than 750, preferably less than 500 and having a plurality of hydroxyl (-OH) groups. As with the monomeric polycarboxylic acid component, if the monomeric polyol component has a distribution of molecular weights then for purpose of this definition the molecular weight is the number average molecular weight of the distribution. The monomeric polyol component is at least difunctional and is preferably trifunctional or higher. As with the monomeric polycarboxylic acid component, the monomeric polyol component may also have other chemical functional groups (such as a carboxyl), so long as such groups do not interfere with the preparation of the polyester binder. Suitable monomeric polyol components are 1,4-cyclohexanediol, catechol, cyanuic acid, diethanolamine, pryogallol, butanediol, 1,6-hexane diol, 1,2,6 hexanetriol, 1,3 butanediol, 1,4-cyclohexane dimethanol, 2,2,4 trimethylpentanediol, alkoxylated bisphenol A, Bis[N,N di beta-hydroxyethyl)] adipamide, bisphenol A, bisphenol A diglycidyl ether, bisphenol F diglycidyl ether, cyclohexanedimethanol, dibromoneopentyl glycol, diethylene glycol, dipropylene glycol, ethoxylated DETA, ethylene glycol, glycerine, neopentyl glycol, pentaerythritol, low molecular weight polyethylene glycol and polypropylene glycol, propane 1,3 diol, propylene glycol, sorbitol, tartaric acid, tetrabromoalkoxylate bisphenol A, tetrabromobisphenol A, tetrabromobisphenol diethoxy ether, triethanolamine, triethylene glycol, trimethylolethane, trimethylolpropane and tripropylene glycol.

In the broad practice of the present invention, the average functionality of either of the monomeric polycarboxylic acid component or the monomeric polyol component is at least 2.2, preferably at least 2.5, more preferably at least 3.0 and most preferably at least 3.5. It is particularly preferred to have the average functionality of each of the monomeric polycarboxylic acid component and the monomeric polyol component at least 2.2, preferably both at least 2.5 and most preferably both each 3.0. It is particularly contemplated that both components may have an average functionality of at least 3.0 and possibly at least 3.5. The average functionality of the monomeric polycarboxylic acid component (MPAC), for example, can be calculated as follows:
The Sum of (the number of moles of $MPAC_i$ times the functionality of $MPAC_i$ (for MPACs 1 through n)) divided by the total number of moles of MPACs 1 through n.

The average functionality of a mixture of monomeric polyol components (MPC) is similarly calculated.

For example, for a mixture of 1 mole of ethylene glycol and 2 moles of pentaerythritol, the average functionality of the monomeric polyol component is:

$$((1 \cdot 2) + (2 \cdot 4))/(1+2) = (2+8)/3 = 3.3$$

It is also possible to include a small amount of monofunctional acid or alcohol material, such as acrylic acid, methacrylic acid, or phenol in the reaction mixture so long as it does not interfere with the preparation of a polyester binder that when cured exhibits acceptable performance in the insulation product. The use of this material must also be accounted for when computing the average functionality of the respective polycarboxylic acid or polyol component.

It also may be desirable in some instances to include some (generally a small amount of) hydroxy-acids in the reaction mixture. Materials such as glycolic and lactic acid function as difunctional reactants in the polyester reaction and can self polymerize.

In preparing the polyester resin binder, the monomeric polycarboxylic acid and monomeric polyol components are reacted to form a water soluble (substantially infinitely water dilutable or dispersible) polyester resin. It is important to provide an amount of the monomeric polycarboxylic acid component in proportion to an amount of the monomeric polyol component so as to maintain the mole ratio of -COOH contributed by the monomeric polycarboxylic acid component to -OH contributed by the monomeric polyol component (-COOH:-OH) in the range of about 100:1 to about 1:100, more usually in the range of 10:1 to 1:10, most often in the range of 5:1 to 1:5 and most usually in the range of 2:1 to 1:2. This mole ratio is conveniently determined by a ratio of the number of moles of the monomeric polycarboxylic acid component multiplied by the average functionality of the monomeric polycarboxylic acid component to the number of moles of the monomeric polyol component multiplied by the average functionality of the monomeric polyol component. Preferably, the mole ratio of -COOH contributed by the monomeric polycarboxylic acid component to -OH contributed by the monomeric polyol component (-COOH:-OH) in the range of about 2:1 to about 1:2 and more preferably in the range of 1.5:1 to 1:1.5.

These two components are mixed together, often in an aqueous environment, acidified as needed to establish an acidic pH, typically a pH below about 5.0, and then generally reacted at a temperature in the range of about 90° C to about 200° C. While the reaction can be conducted in the absence of known catalysts, often, the reaction is conducted in the presence of a catalyst that promotes the reaction between the polyacid component and the polyol component. Reaction conditions for making polyesters are well known to the skilled worker and can be used for making the polyester binder of this invention. The reaction conditions presented above are exemplary. Preferably, the reaction is conducted in a reactor that allows for the removal of water generated during the formation of the polyester and water is removed as the reaction proceeds.

Suitable catalysts that optionally can be used for promoting the reaction between the monomeric polycarboxylic acid component and the monomeric polyol component include: inorganic acids, such as sulfuric acid, lead acetate, sodium acetate, calcium acetate, zinc acetate, organotin compounds, titanium esters, antimony trioxide, germanium salts, ammonium chloride, sodium hypophosphite, sodium phosphite and organic acids such as methane sulfonic acid and para toluene sulfonic acid.

The reaction is generally allowed to proceed no further than the point of incipient insolubility/precipitation such that the polyester remains water soluble, i.e., substantially infinitely water dilutable, or at least substantially infinitely water-dispersible. In particular, the reaction is conducted such that there are residual carboxylic groups in the polyester resin, which are believed to contribute to the water dilutability characteristics of the resin. Preferably, the reaction is allowed to proceed such that the acid number of the polyester resin does not fall below about 100, often not below 150, and usually not below 200. Acid numbers for the polyester above 300 and particularly around 400 and above are not uncommon. In an alternative embodiment, it is possible to produce a resin that is substantially infinitely water-dilutable, or at least substantially infinitely water-dispersible from a resin that otherwise may not be, by forming a salt of the resin, such as by adding a base such as ammonium hydroxide to the resin to solubilize the resin. Thus, in the broad practice of the present invention a substantially infinitely water-dilutable or dispersible adduct of a monomeric polycarboxylic acid component and a monomeric polyol component includes polyester resin salts.

The polycarboxylic acid and polyol components used in preparing the polyester resin will have a significant impact on whether the polyester is infintely water-dilutable or infinitely water-dispersible. As used herein, the term water-dilutable and water-dispersible refers to the ability to add water to the polyester resin without causing any significant precipitation of solids. Preferably no precipitation of solids occurs on the addition of water to the aqueous resin. In particular, the phrase substantially infinitely water-dilutable or infinitely water-dispersible means that a stable aqueous binder composition can be prepared from the polyester resin and diluted to a solids concentration as low as 0.1 wt. % solids.

When using higher poly-functional reactants care must be taken not to advance the original reaction to far, or the polyester resin may gel (crosslink rather than branch) and not be useful. The way to avoid premature gelation is to limit the extent of the esterification reaction, i.e., the reaction between the polyol and the polycarboxylic acid. In any event, when preparing the polyester resin the target acid titer should not be too low, sometimes 400 and above, or the resin may crosslink to a gel. As noted above, the reaction also is conducted in a reactor that allows for the removal of water generated during the formation of the polyester and may be continued until the desired acid number is reached.

The reaction between the MPAC and MPC often is conducted under substantially anhydrous conditions so that the desired extent of the esterification reaction can conveniently be monitored simply by measuring the amount of water evolved as the reaction proceeds. The presence of any significant amount of water at the outset of the esterification reaction may interfere with this method of monitoring the desired end point of the reaction. The present invention is not limited to any particular method for assessing the end point of the esterification reaction, however.

The polyester binder of the present invention differs from the prior art in that both the acid and alcohol components are supplied as monomeric constituents and the monomeric carboxylic acid component and the monomeric polyol component are partially reacted with each other before using them to form the aqueous binder composition. In this way, the potential for smoke generation when curing the binder is reduced. In much of the prior art, the polyol and (polymeric) polyacid components are supplied simply as a mixture in the binder formulation and are not reacted together until they are cured in the presence of the glass fibers. One particular approach uses a polymeric polyacid, such as polyacrylic acid, presumably as a way of building molecular weight in the binder to minimize the time and temperature needed to cure the binder. The binder of the present invention thus is based on a fundamentally different approach.

In operation, the polyester binder of the present invention is formulated into a dilute aqueous solution and then is usually applied to glass fibers as they are being produced and formed into a mat or blanket, water is volatilized from the binder, and the high-solids binder-coated fibrous glass mat is heated to cure the binder and thereby produce a finished glass fiber product, e.g., fiberglass insulation product.

The polyester-based binder solution for making glass fiber products in accordance with the present invention is generally provided as a water soluble or water dispersable composition which can be easily blended with other ingredients and diluted to a low concentration which is readily sprayed onto the fibers as they fall onto the collecting conveyor. The binder composition is generally applied in an amount such that the cured binder constitutes about 5 wt. % to about 15 wt. % of the finished glass fiber products, e.g., fiberglass insulation product, although it can be as little as 1 wt. % or less and as high as 20 wt. % or more, depending upon the type of glass fiber product. Optimally, the amount of binder for most thermal insulation products will be the amount necessary to lock each fiber into the mass by bonding the fibers where they cross or overlap. For this reason, it is desired to have binder compositions with good flow characteristics, so that the binder solution can be applied to the fiber at a low volume that will flow to the fiber intersections.

The ultimate binder composition for application to the glass fibers may comprise a variety of liquid forms, including solutions, miscible liquids, or dispersions and the like and combinations of such liquid forms depending upon the optional ingredients blended into the binder composition. Where the term solution or any of the variations thereof is used herein it is intended to include any relatively stable liquid phase.

The binder formulation should be infinitely dilutable or dispersibly in order to permit variations in concentrations for different end products. Generally, the binder formulation also should be relatively stable for periods of time long enough to permit mixing and application to the glass fibers at temperatures ordinarily encountered in glass fiber product manufacturing facilities, such as fiberglass insulation product manufacturing plants, typically greater than 4 hours. Alternatively, if the glass fiber manufacturer has an in-line binder mixing system, the polyester binder may be diluted and immediately applied to the fibers. In this circumstance, stability is less of a conccern. The cured binder must provide a strong bond with sufficient elasticity and thickness recovery to permit reasonable shipping and in-service deformation of the glass fiber product, particularly, fiberglass insulation products. It also should be moisture resistant so that it does not swell under humid conditions. Additionally, it should be odor free and noncorrosive to metals with which it comes in contact. The binder should be capable of withstanding temperatures approaching the temperatures that the glass fibers can withstand, particularly for pipe insulation where the pipeline is used for hot fluids.

To prepare a binder formulation, it may also be advantageous to add a silane coupling agent (e.g., organo silicon oil) to the polyester resin composition in an amount of at least about 0.05 wt. % based on the weight of binder solids. Suitable silane coupling agents (organo silicon oils and fluids) have been marketed by the Dow-Coming Corporation, Petrarch Systems, and by the General Electric Company. Their formulation and manufacture are well known such that detailed description thereof need not be given. When employed in the binder composition of this invention, the silane coupling agents typically are present in an amount within the range of about 0.1 to about 2.0 percent by weight based upon the binder solids and preferably in an amount within the range of 0.1 to 0.5 percent by weight. Representative silane coupling agents are the organo silicon oils marketed by Dow-Coming Corporation; A0700, A0750 and A0800 marketed by Petrarch Systems and A1100 (an amino propyl, trimethoxy silane) or A1160 marketed by Dow Chemical Corporation. This invention is not directed to and thus is not limited to the use of any particular silane additives.

The binder may be prepared by combining the polyester resin composition and the silane coupling agent in a relatively easy mixing procedure carried out at ambient temperatures. The binder can be used immediately and may be diluted with water to a concentration suitable for the desired method of application, such as by spraying onto the glass fibers.

The polyester binder composition may also contain a catalyst which would be used in an amount of 10 wt. % or less, more usually 0.01 to 10 wt. %, even more typically 0.1 wt. % to 5 wt. %, and most often 0.5 wt. % to 2 wt. %, based on the combined weight of the polyester solids. Suitable catalysts include sulfuric acid, lactic acid, lead acetate, sodium acetate, calcium acetate, zinc acetate, organotin compounds, titanium esters, antimony trioxide, germanium salts, ammonium chloride, sodium hypophosphite, sodium phosphite, methane sulfonic acid and para toluene sulfonic acid. Other catalysts that could be used will be apparent to those skilled in the art and the present invention is not limited to any particular catalyst composition.

Other conventional binder additives compatible with the polyester resin composition and silane coupling agent also may be added to the binder destined for application to the glass fibers. Such additives include such conventional treatment components as, for example, emulsifiers, pigments, fillers, anti-migration aids, curing agents, coalescents, wetting agents, dedusting agents, biocides, plasticizers, anti-foaming agents, colorants, waxes, and anti-oxidants

The particular method for forming glass fibers for use in the present invention is relatively unimportant. Processes for making glass fiber products, and especially fiberglass insulation products using a polyester binder resin of the present invention are typically carried out according to one of a number of methods wherein a molten mineral material flowing from a melting furnace is divided into streams and attenuated into fibers. The attenuation can be done by centrifuging and/or fluid jets to form discontinuous fibers of relatively small dimensions which typically are collected by randomly depositing on a moving foraminous (porous) conveyor belt. The fibers are collected in a felted haphazard manner to form a mat. The volume of fiber in the mat will be determined by the speed of fiber formation and the speed of the belt.

Continuous glass fibers also may be employed in the form of mats or blankets fabricated by swirling the endless filaments or strands of continuous fibers, or they may be chopped or cut to shorter lengths for mat or batt formation. Use can also be made of ultra-fine fibers formed by the attenuation of glass rods. Also, such fibers may be treated with a size, anchoring agent or other modifying agent before use.

Glass fiber insulation products may also contain fibers that are not in themselves heat-resistant such as, for example, certain polyester fibers, rayon fibers, nylon fibers, and superabsorbent fibers, in so far as they do not materially adversely affect the performance of the glass fiber product.

In order to produce most glass fiber products and especially fiberglass thermal insulation products, the fibers must be bonded together in an integral structure. To achieve this binding, the curable polyester binder material of the present invention is applied to the glass fiber mat or blanket. When making fiberglass insulation, the layer of fiber with binder is then mildly compressed and shaped into the form and dimensions of the desired thermal insulation product. The insulation product then is passed through a curing oven where the binder is cured fixing the size and shape of the finished insulation product.

The polyester binder composition may be applied to the fiberglass by conventional techniques such as, for example, air or airless spraying, padding, saturating, roll coating, curtain coating, beater deposition, and coagulation. For example, the polyester binder can be applied to the glass fibers by flooding the collected mat of glass fibers and draining off the excess, by applying the binder composition onto the glass fibers during mat or blanket formation, by spraying the glass fiber mat or the like. As noted above, the layer of fiber with binder can then be mildly compressed and shaped into the form and dimensions of the desired insulation product such as pipe, batt or board and passed through a curing oven where the binder is cured, thus fixing the size and shape of the finished insulating product by bonding the mass of fibers one to another and forming an integral composite structure.

The aqueous polyester binder, after it is applied to the glass fiber, is heated to effect drying and curing. The duration and temperature of heating will affect the rate of drying, processability and handleability, degree of curing and property development of the treated substrate. The curing temperatures are within the range from 75 to 300° C., preferably within the range from 90 to 250° C. and the curing time will usually be somewhere between 3 seconds to about 15 minutes.

On heating, water present in the binder composition evaporates, and the composition undergoes curing. These processes can take place in succession or simultaneously. Curing in the present context is to be understood as meaning the chemical alteration of the composition, for example crosslinking through formation to covalent bonds between the various constituents of the composition, formation of ionic interactions and clusters, formation of hydrogen bonds. Furthermore, the curing can be accompanied by physical changes in the binder, for example phase transitions or phase inversion.

As noted, the drying and curing functions may be effected in two or more distinct steps, if desired. For example, the composition may be first heated at a temperature and for a time sufficient to substantially dry but not to substantially cure the binder composition and then heated for a second time at a higher temperature and/or for a longer period of time to effect curing. Such a procedure, referred to as "B-staging", may be used to provide binder-treated product, for example, in roll form, which may at a later stage be cured, with or without forming or molding into a particular configuration, concurrent with the curing process. This makes it possible, for example, to use the compositions of this invention for producing binder-impregnated semifabricates which can be molded and cured elsewhere.

The glass fiber component will represent the principal material of the glass fiber products, such as a fiberglass insulation product. Usually 99-60 percent by weight of the product will be composed of the glass fibers, while the amount of polyester binder solids will broadly be in reverse proportion ranging from 1-40 percent, depending upon the density and character of the product. Glass insulations having a density less than one pound per cubic foot may be formed with binders present in the lower range of concentrations while molded or compressed products having a density as high as 30-40 pounds per cubic foot can be fabricated of systems embodying the binder composition in the higher proportion of the described range.

Glass fiber products can be formed as a relatively thin product, such as a mat having a thickness of about 10 to 50 mils; or they can be formed as a relatively thick product, such as a blanket of 12 to 14 inches or more. Glass fiber products of any thickness are embraced by the present invention. The time and temperature for cure for any particular glass fiber product will depend in part on the amount of binder in the final structure and the thickness and density of the structure that is formed and can be determined by one skilled in the art using only routine testing. For a structure having a thickness ranging from 10 mils to 1.5 inch, a cure time ranging from several seconds to 1-5 minutes usually will be sufficient at a cure temperature within the range of 175°-300° C.

Glass fiber products may be used for applications such as, for example, insulation batts or rolls, as reinforcing mat for roofing or flooring applications, as roving, as microglass-based substrate for printed circuit boards or battery separators, as filter stock, as tape stock, and as reinforcement scrim in cementitious and non-cementitious coatings for masonry.

EXAMPLE 1

A polyester resin binder of the present invention, was prepared as follows. Water (250 parts by weight), butane tetracarboxylic acid (158 parts by weight) and pentaerythritol (92 parts by weight) were added to a reaction vessel equipped with reflux (for cooling), a heater, and a mixer. The reactor also permitted the removal of water generated by the condensation reaction. The temperature of the agitated aqueous mixture was slowly adjusted to 115° C and held there for four (4) hours. Every thirty (30) minutes, the Acid Number and Water Dilute were monitored. The final Acid Number for the polyester resin was about 439. The polyester resin can be recovered by cooling and hardening the reaction product in a pan. Alternatively, the resin may be directly diluted with water to a desired solids level to facilitate handling, storage and transport of the resin binder.

EXAMPLE 2

A polyester resin binder of the present invention, was prepared as follows. Sorbitol (202 parts by weight) and citric acid (298 parts by weight) were added to a reaction vessel equipped with reflux (for cooling), a heater, and a mixer. The reactor also permitted the removal of water generated by the condensation reaction. The temperature of the agitated mixture was slowly adjusted to 115° C and held there for four (4) hours. Every thirty (30) minutes, the Acid Number and Water Dilute were monitored. The polyester resin can be recovered by cooling and hardening the reaction product in a pan. Alternatively, the resin may be directly diluted with water to a desired solids level to facilitate handling, storage and transport of the resin binder.

EXAMPLE 3

A glass fiber binder was prepared using the polyester resin of Example 1 as follows: 50 grams of the resin of Example 1 was mixed with 2.8 grams of 88% by weight lactic acid, 1.3 grams of 30% A1102 silane and 196.2 grams of water to prepare a binder containing 20 weight percent solids. The ingredients were added to a ½ gallon jar and mixed well.

EXAMPLE 4

A binder formulation was prepared using the polyester resin of Example 2 as follows: 78 grams of the resin of Example 2 was mixed with 3.9 grams of 88% by weight lactic acid (in the broad practice of the invention any acid should be suitable), 31.5 grams of a 70% aqueous solution of sorbitol, 1.3 grams of 30% A1102 silane and 385.3 grams of water to prepare a binder containing 20 weight percent solids. The ingredients were added to a ½ gallon jar and mixed well.

EXAMPLE 5

Wet tensile strengths of hand sheets prepared using the curable aqueous binder compositions of Examples 3 and 4 were examined. Hand sheets were prepared by sprinkling the binder onto a glass mat, formed from ½ inch PPG M-8035 chopped glass fibers dispersed in water containing a polyacrylamide, vacuuming the excess binder off the glass fibers and then curing the sheet in an oven at 200 to 240° C for 1 to 5 minutes.

Hot/wet tensile strength of mats prepared using the binder of Examples 4 and 5 were then measured by soaking the handsheets in 185° F (85° C) water for 10 minutes. Samples of the hand sheets (3 inches by 5 inches) were then subjected to breaking a tensile tester (QC-1000 Materials Tester by the Thwing lbert Instrument Co.) while they were still hot and wet. The hand sheet made from the binder of Example 4 exhibited a hot/wet tensile strength of 30 pounds; while the hand sheet made using the binder of Example 5 exhibited a hot/wet tensile of 28 pounds. A typical PF resin binder exhibits a hot/wet tensile of about 35 pounds.

EXAMPLE 6

A polyester resin binder of the present invention, was prepared as follows. 70% sorbitol (431 parts by weight) and citric acid (319 parts by weight) were added to a reaction vessel equipped with reflux (for cooling), a heater, and a mixer. The reactor also permitted the removal of water generated by the condensation reaction. The temperature of the agitated mixture was slowly adjusted to 115° C and held there for two (2) hours. Every thirty (30) minutes, the Water Dilute was monitored. The final Acid Number for the polyester resin was about 312. The polyester resin can be recovered by cooling and hardening the reaction product in a pan. Alternatively, the resin may be directly diluted with water to a desired solids level to facilitate handling, storage and transport of the resin binder.

EXAMPLE 7

A polyester resin binder of the present invention, was prepared as follows. 70% sorbitol (202 parts by weight) and citric acid (298 parts by weight) were added to a reaction vessel equipped with reflux (for cooling), a heater, and a mixer. The reactor also permitted the removal of water generated by the condensation reaction. The temperature of the agitated mixture was slowly adjusted to 115° C and held there for four (4) hours. Every thirty (30) minutes, the Acid Number and Water Dilute were monitored. The final Acid Number for the polyester resin was about 312. The polyester resin can be recovered by cooling and hardening the reaction product in a pan. Alternatively, the resin may be directly diluted with water to a desired solids level to facilitate handling, storage and transport of the resin binder.

EXAMPLE 8

A polyester resin binder of the present invention, was prepared as follows. Maleic anhydride (237 parts by weight), triethanolamine (234 parts by weight) and water (29 parts by weight) were added to a reaction vessel equipped with reflux (for cooling), a heater, and a mixer. The reactor also permitted the removal of water generated by the condensation reaction. The temperature of the agitated mixture was slowly adjusted to 115° C and held there for four (4) hours. Every thirty (30) minutes, the Acid Number and Water Dilute were monitored. The polyester resin can be recovered by cooling and hardening the reaction product in a pan. Alternatively, the resin may be directly diluted with water to a desired solids level to facilitate handling, storage and transport of the resin binder.

**Claims**

1. An aqueous binder composition for making glass fiber products comprising a substantially infinitely water-dilutable or dispersible thermosetting adduct of a monomeric polycarboxylic acid component having a molecular weight of less than 750 and a monomeric polyol component having a molecular weight of less than 750, or a substantially infinitely water-dilutable or dispersible ammonium salt of said thermosetting adduct, wherein at least one of the monomeric polycarboxylic acid component and the monomeric polyol component has an average functionality of at least 2.2 and wherein said adduct has residual carboxylic groups and an acid number of 100 or above.

2. The aqueous binder composition of claim 1 wherein the monomeric polycarboxylic acid component has a molecular weight less than 500 and has a plurality of carboxylic acid moieties.

3. The aqueous binder composition of claim 1 wherein the monomeric polycarboxylic acid component is selected from the group consisting of aconitic acid, adipic acid, azelaic acid, butane tetra carboxylic acid dihydride, butane tricarboxylic acid, chlorendic anhydride, citraconic acid, citric acid, dicyclopentadiene-maleic acid adducts, diethylenetriamine pentacetic acid pentasodium salt, adducts of dipentene and maleic anhydride, endomethylenehexachlorophthalic anhydride, ethylenediamine tetraacetic acid (EDTA), fully maleated rosin, maleated tall oil fatty acids, fumaric acid, glutaric acid, isophthalic acid, itaconic acid, maleated rosin with sites of unsaturation oxidized with potassium peroxide to alcohol and then to carboxylic acid, malic acid, maleic anhydride, mesaconic acid, biphenol A reacted via KOLBE-Schmidt reaction with carbon dioxide to introduce 3 to 4 carboxyl groups, bisphenol F reacted via KOLBE-Schmidt reaction with carbon dioxide to introduce 3 to 4 carboxyl groups, oxalic acid, phthalic anhydride, polylactic acid, sebacic acid, succinic acid, tartaric acid, terephthalic acid, tetrabromophthalic anhydride, tetrachlorophthalic anhydride, tetrahydrophthalic anhydride, trimellitic anhydride and trimesic acid.

4. The aqueous binder composition of claim 2 wherein the monomeric polyol component has a molecular weight less than 500 and has a plurality of hydroxyl groups.

5. The aqueous binder composition of claim 1 wherein the monomeric polyol component is selected from the group consisting of 1,4-cyclohexanediol, catechol, cyanuic acid, diethanolamine, pryogallol, butanediol, 1,6-hexane diol, 1,2,6 hexanetriol, 1,3 butanediol, 1,4-cyclohexane dimethanol, 2,2,4 trimethylpentanediol, alkoxylated bisphenol A, Bis[N,N di beta-hydroxyethyl)] adipamide, bisphenol A, bisphenol A diglycidyl ether, bisphenol F diglycidyl ether, cyclohexanedimethanol, dibromoneopentyl glycol, diethylene glycol, dipropylene glycol, ethoxylated DETA, ethylene glycol, glycerine, neopentyl glycol, pentaerythritol, low molecular weight polyethylene glycol, low molecular weight polypropylene glycol, propane 1,3 diol, propylene glycol, sorbitol, tartaric acid, tetrabromoalkoxylate bisphenol A, tetrabromobisphenol A, tetrabromobisphenol diethoxy ether, triethanolamine, triethylene glycol, trimethylolethane, trimethylolpropane and tripropylene glycol.

6. The aqueous binder composition of claim 1 wherein the monomeric polycarboxylic acid component and the monomeric polyol component have average functionalities of at least 2.5.

7. The aqueous binder composition of claim 6 wherein the monomeric polycarboxylic acid component and the monomeric polyol component are provided in amounts to provide a mole ratio of -COOH to -OH (-COOH:-OH) in the range of about 2:1 to 1:2.

8. A method for binding together a loosely associated mat of glass fibers comprising (1) contacting said glass fibers with the aqueous binder composition according to any one of claims 1 to 7, and (2) heating said aqueous binder composition at an elevated temperature sufficient to effect cure.

9. A glass fiber product comprising a crosslinked (cured) composition obtained by curing (drying with heat) an aqueous binder composition according to any one of claims 1 to 7 applied to a mat of nonwoven glass fibers.

10. The glass fiber product of claim 9 wherein the glass fiber product is made from heat resistant fibers.

11. The glass fiber product of claim 9 wherein the glass fiber product is a fiberglass insulation product.

12. The aqueous binder composition of claim 2, wherein the monomeric polycarboxylic acid component has an average functionality of at least 3.0

13. The aqueous binder composition of claim 12, wherein the monomeric polyol component has an average functionality of at least 3.0.

**Patentansprüche**

1. Eine wässrige Bindemittelzusammensetzung für die Herstellung von Glasfaserprodukten umfassend im Wesentlichen unbegrenzt mit Wasser verdünnbares oder dispergierbares wärmehärtbares Addukt einer monomeren Polycarbonsäure-Komponente mit einem Molekulargewicht von weniger als 750 und einer monomeren Polyol-Komponente mit einem Molekulargewicht von weniger als 750 oder ein im Wesentlichen unbegrenzt mit Wasser verdünnbares oder dispergierbares Ammoniumsalz von diesem wärmehärtbaren Addukt, wobei wenigstens eine der monomeren Polycarbonsäure-Komponenten und die monomere Polyol-Komponente eine durchschnittliche Funktionalität von mindestens 2,2 hat und wobei das genannte Addukt restliche Carboxyl-Gruppen und eine Säurezahl von 100 oder mehr aufweist.

2. Die wässrige Bindemittelzusammensetzung nach Anspruch 1, wobei die monomere Polycarbonsäure-Komponente ein Molekulargewicht von weniger als 500 und eine Pluralität von Carboxylsäure-Anteilen aufweist.

3. Die wässrige Bindemittelzusammensetzung nach Anspruch 1, wobei die monomere Polycarbonsäure-Komponente ausgewählt ist aus einer Gruppe bestehend aus Akonitsäure, Adipinsäure, Azelainsäure, Butantetracarbonsäuredihydrid, Butantricarbonsäure, 1,4,5,6,7,7-Hexachloro-5-norbornen-2,3-dicorbonsäureanhydrid, Citraconsäure, Zitronensäure, Dicyclopentadienmaleinsäureaddukte, Diethylentriaminpentaessigsäurepentanatriumsalz, Addukte aus Dipenten und Maleinanhydrid, Endomethylenhexachlorophthalsäureanhydrid, Ethylendiamintetraessigsäure (EDTA), vollmaleiniertes Kolophonium, maleinierte Tallölfettsäuren, Fumarsäure, Glutarsäure, Isophthalsäure, Itaconsäure, maleiniertes Kolophonium mit ungesättigen Positionen mit Kaliumperoxid zum Alkohol und dann zur Carbonsäure oxidiert, Äpfelsäure, Maleinsäure, Mesaconsäure, Bisphenol A mit Kohlendioxid in einer KOLBE-Schmitt-Reaktion umgesetzt um 3 bis 4 Carboxyl-Gruppen einzuführen, Bisphenol F mit Kohlendioxid in einer KOLBE-Schmitt-Reaktion umgesetzt um 3 bis 4 Carboxyl-Gruppen einzuführen, Oxalsäure, Phthalsäureanhydrid, Polymilchsäure, Sebacinsäure, Bernsteinsäure, Weinsäure, Terephthalsäure, Tetrabromophthalsäureanhydrid, Tetrachlorophthalsäureanhydrid, Tetrahydrophthalsäureanhydrid, Trimellitsäureanhydrid und Trimesinsäure.

4. Die wässrige Bindemittelzusammensetzung nach Anspruch 2, wobei die monomere Polyol-Komponente ein Molekulargewicht von weniger als 500 und eine Pluralität von Hydroxyl-Gruppen hat.

5. Die wässrige Bindemittelzusammensetzung nach Anspruch 1, wobei die monomere Polyol-Komponente ausgewählt ist aus einer Gruppe bestehend aus 1,4-Cyclohexandiol, Brenzcatechin, Cyanursäure, Diethanolamin, Pyrogallol, Butandiol, 1,6-Hexandiol, 1,2,6-Hexantriol, 1,3-Butandiol, 1,4-Cyclohexandimethanol, 2,2,4-Trimethylpentandiol, alkoxyliertes Bisphenol A, Bis-[N,N-dibetahydroxyethyl]adipinsäureamid, Bisphenol A, Bisphenol A-diglycidylether, Bisphenol F-diglycidylether, Cyclohexandimethanol, Dibromoneopentylglykol, Diethylenglykol, Dipropylenglykol, ethoxyliertes DETA, Ethylenglykol, Glycerin, Neopentylglykol, Pentaerythritol, niedermolekulares Polyethylenglykol, niedermolekulares Polypropylenglykol, Propan-1,3-diol, Propylenglykol, Sorbitol, Weinsäure, tetrabromoalkoxyliertes Bisphenol A, Tetrabromobisphenol A, Tetrabromobisphenoldiethoxyether, Triethanolamin, Triethylenglykol, Trimethylolethan, Trimethylolpropan und Tripropylenglykol.

6. Die wässrige Bindemittelzusammensetzung nach Anspruch 1, wobei die monomere Polycarbonsäure-Komponente und die monomere Polyol-Komponente eine durchschnittliche Funktionalität von mindestens 2,5 besitzt.

7. Die wässrige Bindemittelzusammensetzung nach Anspruch 6, wobei die monomere Polycarbonsäure-Komponente und die monomere Polyol-Komponente in solchen Mengen zur Verfügung gestellt werden, die ein molares Verhältnis von COOH zu OH (COOH : OH) im Bereich zwischen etwas 2 : 1 und 1 : 2 hervorrufen.

8. Eine Verfahren zum Binden eines lockeren Vlieses von Glasfasern umfassend (1) in Kontakt bringen der genannten Glasfasern mit der wässrigen Bindemittelzusammensetzung gemäß einem der Ansprüche 1 bis 7, und (2) Erhitzen der genannten wässrigen Bindemittelzusammensetzung auf eine derart erhöhte Temperatur, dass diese ausreichend ist, um Härtung zu bewirken.

9. Ein Glasfaserprodukt, umfassend eine quervernetzte (gehärtete) Komponente, erhalten durch Härtung (hitzegetrocknet) einer wässrigen Bindemittelzusammensetzung gemäß einem der Ansprüche 1 bis 7, verwendet auf einen Vlies von nicht-verwobenen Glasfasern.

10. Das Glasfaserprodukt nach Anspruch 9, wobei das Glasfaserprodukt aus hitzebeständigen Fasern hergestellt ist.

**11.** Das Glasfaserprodukt nach Anspruch 9, wobei das Glasfaserprodukt ein Glasfaserisolationsprodukt ist.

**12.** Die wässrige Bindemittelzusammensetzung nach Anspruch 2, wobei die monomere Polycarbonsäure-Komponente eine durchschnittliche Funktionalität von mindestens 3,0 aufweist.

**13.** Die wässrige Bindemittelzusammensetzung nach Anspruch 12, worin die monomere Polyol-Komponente eine durchschnittliche Funktionalität von mindestens 3,0 aufweist.

**Revendications**

**1.** Composition aqueuse de liant pour la fabrication de produits à base de fibres de verre, comprenant un produit d'addition thermodurcissable, à peu près infiniment diluable ou dispersible dans l'eau, d'un composant monomère de type acide polycarboxylique, ayant un poids moléculaire de moins de 750, et d'un composant monomère de type polyol, ayant un poids moléculaire de moins de 750, ou un sel d'ammonium à peu près infiniment diluable ou dispersible dans l'eau du dit produit d'addition thermodurcissable, dans laquelle au moins l'un des composants choisis parmi le composant monomère de type acide polycarboxylique et le composant monomère de type polyol a un nombre moyen de fonctions d'au moins 2,2, et dans laquelle ledit produit d'addition comporte des groupes carboxylique résiduels et a un indice d'acide de 100 ou plus.

**2.** La composition aqueuse de liant de la revendication 1, dans laquelle le composant monomère de type acide polycarboxylique a un poids moléculaire inférieur à 500 et comporte plusieurs parties acide carboxylique.

**3.** La composition aqueuse de liant de la revendication 1, dans laquelle le composant monomère de type acide polycarboxylique est choisi parmi le groupe consistant en l'acide aconitique, l'acide adipique, l'acide azélaïque, le dihydrure d'acide butane tétracarboxylique, l'acide butane tricarboxylique, l'anhydride chlorendique, l'acide citraconique, l'acide citrique, les produits d'addition du dicyclopentadiène et de l'acide maléique, le sel de pentasodium de l'acide diéthylènetriamine pentacétique, les produits d'addition du dipentène et de l'anhydride maléique, l'anhydride endométhylènehexachlorophtalique, l'acide éthylènediamine tétracétique (EDTA), la colophane saturée de groupes maléate, les acides gras de tallol à groupe maléate, l'acide fumarique, l'acide glutarique, l'acide isophtalique, l'acide itaconique, la colophane à groupe maléate avec des sites d'insaturation oxydés avec du peroxyde de potassium en alcool et ensuite en acide carboxylique, l'acide malique, l'anhydride maléique, l'acide mésaconique, le bisphénol A ayant réagi par la réaction de KOLBE-Schmidt avec du dioxyde de carbone pour introduire de 3 à 4 groupes acide carboxyle, le bisphénol F ayant réagi par la réaction de KOLBE-Schmidt avec du dioxyde de carbone pour introduire de 3 à 4 groupes carboxyle, l'acide oxalique, l'anhydride phtalique, l'acide polylactique, l'acide sébacique, l'acide succinique, l'acide tartrique, l'acide téréphtalique, l'anhydride tétrabromophtalique, l'anhydride tétrachlorophtalique, l'anhydride tétrahydrophtalique, l'anhydride trimellique et l'acide trimésique.

**4.** La composition aqueuse de liant de la revendication 2, dans laquelle le composant monomère de type polyol a un poids moléculaire inférieur à 500, et comporte plusieurs groupes hydroxy.

**5.** La composition aqueuse de liant de la revendication 1, dans laquelle le composant monomère de type polyol est choisi parmi le groupe consistant en le 1,4-cyclohexanediol, le catéchol, l'acide cyanurique, la diéthanolamine, le pyrogallol, le butanediol, le 1,6-hexane diol, le 1,2,6-hexanetriol, le 1,3-butane diol, le 1,4-cyclohexane diméthanol, le 2,2,4-triméthylpentanediol, le bisphénol A alkoxylé, le bis[N,N-di (bêta-hydroxyéthyl)] adipamide, le bisphénol A, l'éther diglycidylique de bisphénol A, l'éther diglycidylique de bisphénol F, le cyclohexanediméthanol, le dibromonéopentyl glycol, le diéthylène glycol, le dipropylène glycol, le DETA éthoxylé, l'éthylène glycol, la glycérine, le néopentyl glycol, le pentaérythritol, le polyéthylène glycol de faible poids moléculaire, le polypropylène glycol de faible poids moléculaire, le propane 1,3-diol, le propylène glycol, le sorbitol, l'acide tartrique, le bisphénol A tétrabromoalkoxylé, le tétrabromobisphénol A, le diéthoxy éther de tétrabromobisphénol, la triéthanolamine, le triéthylène glycol, le triméthyloléthane, le triméthylolpropane et le tripropylène glycol.

**6.** La composition aqueuse de liant de la revendication 1, dans laquelle le composant monomère de type acide polycarboxylique et le composant monomère de type polyol ont un nombre moyen de fonctions d'au moins 2,5.

**7.** La composition aqueuse de liant de la revendication 6, dans laquelle le composant monomère de type acide polycarboxylique et le composant monomère de type polyol sont fournis en des quantités pour procurer un rapport molaire entre groupes -COOH et -OH (-COOH : -OH) dans la plage d'environ 2 : 1 à 1 : 2.

**8.** Procédé pour lier ensemble un mat de fibres de verre librement associées, comprenant (1) la mise en contact des dites fibres de verre avec la composition aqueuse de liant selon l'une quelconque des revendications 1 à 7, et (2) le chauffage de ladite composition aqueuse de liant à une température élevée suffisante pour effectuer un durcissement.

**9.** Produit à base de fibres de verre, comprenant une composition réticulée (durcie), obtenue par durcissement (séchage à la chaleur) d'une composition aqueuse de liant selon l'une quelconque des revendications 1 à 7, appliquée sur un mat de fibres de verre non-tissées.

**10.** Le produit à base de fibres de verre de la revendication 9, dans lequel le produit à base de fibres de verre est fabriqué à partir de fibres résistantes à la chaleur.

**11.** Le produit à base de fibres de verre de la revendication 9, dans lequel le produit à base de fibres de verre est un produit isolant à base de fibres de verre.

**12.** La composition aqueuse de liant de la revendication 2, dans laquelle le composant monomère de type acide polycarboxylique a un nombre moyen de fonctions d'au moins 3,0.

**13.** La composition aqueuse de liant de la revendication 12, dans laquelle le composant monomère de type polyol a un nombre moyen de fonctions d'au moins 3,0.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5318990 A
- US 5340868 A
- US 5393849 A
- US 5661213 A
- US 5932689 A
- US 5977232 A
- US 6114464 A
- US 6171654 B
- US 6331350 B